(19) Europäisches Patentamt
European Patent Office
Office européen des brevets

(11) **EP 3 951 828 B1**

(12) **EUROPEAN PATENT SPECIFICATION**

(45) Date of publication and mention
of the grant of the patent:
**27.12.2023 Bulletin 2023/52**

(21) Application number: **20916250.2**

(22) Date of filing: **12.10.2020**

(51) International Patent Classification (IPC):
**H01J 37/304** (2006.01)  **H01J 37/30** (2006.01)
**H01J 37/153** (2006.01)  **B33Y 30/00** (2015.01)

(52) Cooperative Patent Classification (CPC):
**H01J 37/3007; B33Y 30/00; H01J 37/153;
H01J 37/304;** H01J 2237/1532; H01J 2237/30472

(86) International application number:
**PCT/CN2020/120391**

(87) International publication number:
**WO 2021/232659 (25.11.2021 Gazette 2021/47)**

(54) **ELECTRON GUN WITH AUTOMATIC ASTIGMATISM ELIMINATION, AND AUTOMATIC ASTIGMATISM ELIMINATION METHOD OF AN ELECTRON GUN**

ELEKTRONENKANONE MIT AUTOMATISCHER ASTIGMATISMUSBESEITIGUNG UND VERFAHREN ZUR AUTOMATISCHEN ASTIGMATISMUSBESEITIGUNG EINER ELEKTRONENKANONE

CANON À ÉLECTRONS AVEC ÉLIMINATION AUTOMATIQUE DE L'ASTIGMATISME ET PROCÉDÉ D'ÉLIMINATION AUTOMATIQUE DE L'ASTIGMATISME D'UN CANON À ÉLECTRONS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.05.2020 CN 202010425026**

(43) Date of publication of application:
**09.02.2022 Bulletin 2022/06**

(73) Proprietor: **Guilin THD Technology Co., Ltd
Qixing District
Guilin,
Guangxi 541004 (CN)**

(72) Inventors:
 • **HUANG, Xiaodong
  Guilin
  Guangxi 541004 (CN)**
 • **WEI, Shouqi
  Guilin
  Guangxi 541004 (CN)**
 • **FEI, Xiang
  Guilin
  Guangxi 541004 (CN)**
 • **ZHANG, Tong
  Guilin
  Guangxi 541004 (CN)**
 • **SU, Naibo
  Guilin
  Guangxi 541004 (CN)**
 • **WANG, Bin
  Guilin
  Guangxi 541004 (CN)**
 • **DONG, Yang
  Guilin
  Guangxi 541004 (CN)**
 • **GUO, Wenming
  Guilin
  Guangxi 541004 (CN)**
 • **LIANG, Zuming
  Guilin
  Guangxi 541004 (CN)**
 • **HUANG, Guohua
  Guilin
  Guangxi 541004 (CN)**
 • **TANG, Qiang
  Guilin
  Guangxi 541004 (CN)**

**(Cont. next page)**

EP 3 951 828 B1

(74) Representative: **Cleanthous, Marinos**
**IOANNIDES CLEANTHOUS AND CO LLC**
**4 Prometheus Street, 3 Floor**
**1065 Nicosia (CY)**

(56) References cited:
WO-A1-2009/100877      CN-A- 103 143 829
CN-A- 106 340 339        CN-A- 111 477 529
GB-A- 2 002 547

• **BERNERS DAVID ET AL: "Beam position and total current monitor for heavy ion fusion beams", AIP CONFERENCE PROCEEDINGS, vol. 281, 10 July 1992 (1992-07-10), pages 168-174, XP093045654, NEW YORK, US ISSN: 0094-243X, DOI: 10.1063/1.44334 Retrieved from the Internet: URL:https://watermark.silverchair.com/168_ 1_online.pdf?token=AQECAHi208BE49Ooan9kk hW _Ercy7Dm3ZL_9Cf3qfKAc485ysgAABO4wggTq Bgkqh kiG9w0BBwagggTbMllE1wlBADCCBNAGCSqG SIb3DQE HATAeBglghkgBZQMEAS4wEQQMsk5OP_jrnE YcmvnLA gEQgllEoftuTxn43gw55SZC3Uz7X6dZnESsU3O ZLuY 4Pa4CGd6EAO1D_hlLDIB5XOhWM-81-pnBRQ_ MY3-px 91WRmysX06>**

• **Trinkel Fabian ET AL: "Development and Application of Rogowski Coils as Beam Position Monitors", , 1 January 2017 (2017-01-01), pages 1-4, XP093045662, DOI: 10.18429/jacow-ipac2017-mopab054 Retrieved from the Internet: URL:https://accelconf.web.cern.ch/ipac2017 /papers/mopab054.pdf [retrieved on 2023-05-10]**

## Description

## Technical Field

The present invention relates to the technical field of electron beam machining equipment, and particularly relates to an automatic anastigmatic electron gun and an automatic anastigmatic method for an electron gun.

## Background

Due to disalignment of electron beams and the lens caused by a machining error, heterogeneous pole piece material, edge effect of electrode or magnetic pole and charge pollution, the electron gun of electron beam machining equipment results in focusing inconsistency of electron beams in various directions on the working plane, so circular electron beam spots cannot be formed, i.e., astigmation is generated. In the electron gun, the anastigmatic device is used to correct electron beam spot morphology. At present, micro electron beams are used for correction, and the optimum state of correction is judged by human experience through optical observation.

The power of the electron gun in electron beam machining equipment such as electron beam welding machine, electron beam punching machine and electron beam additive manufacturing equipment is relatively large, the electron beam used in correction of electron beam spot morphology is much smaller than that used in machining, the electron beam spot morphology is not scaled proportionally according to the size of the electron beam, and the effect of conventional anastigmatic operation based on the empirical method has high randomness and is difficult to reach the optimum state. To improve the effect of correcting the electron beam spot morphology by the anastigmatic device, the actual value of the electron beam during machining can be used as the value of the electron beam during correction of the electron beam spot morphology, and the exciting current of the windings of the anastigmatic device corresponding to the optimum electron beam spot morphology can be automatically sought according to the detection information of the electron beam spot morphology.

To realize automatic anastigmatic control, it is necessary to solve the detection problem of electron beam spot morphology first, and for electron beam machining equipment with large power, the detecting element for electron beam spot morphology must be non-contact with electron beams to be reused, which meets the production requirements of electron beam machining equipment.

## Summary

The present invention is to solve the problem that the effect of the existing anastigmatic device has high randomness and is difficult to reach the optimum state and to provide an automatic anastigmatic electron gun and an automatic anastigmatic method for an electron gun.

To solve the above problem, the present invention is realized by the following technical solution:

An automatic anastigmatic electron gun comprises a central controller, an electronic source power supply, a drive power supply and an electron gun body; an electron beam generator, an anastigmatic device and a focusing device are arranged in the electron gun body from top to bottom; the anastigmatic device comprises anastigmatic windings with two phases, which form a structure with a plurality of pairs of axisymmetrical magnetic poles; an electron beam control voltage signal output end of the central controller is connected with a control input end of the electronic source power supply, and an output end of the electronic source power supply is connected with the electron beam generator; a first anastigmatic control voltage signal output end of the central controller is connected with a first control input end of the drive power supply, and a first output end of the drive power supply is connected with a first anastigmatic winding of the anastigmatic device; a second anastigmatic control voltage signal output end of the central controller is connected with a second control input end of the drive power supply, and a second output end of the drive power supply is connected with a second anastigmatic winding of the anastigmatic device; the difference lies in further comprising a detection device and a signal processing circuit, wherein the detection device is arranged in the electron gun body and located at an electron beam outlet end directly below the focusing device; the detection device comprises a framework and four detection windings; the framework has a ring structure of non-magnetic conductive insulation material; the four windings have the same number of turns and the same wire diameter, and are wound around the framework and evenly and symmetrically distributed; a first detection winding and a third detection winding are radially oppositely arranged on the framework, and the tail end of the first detection winding is connected with the head end of the third detection winding; a second detection winding and a fourth detection winding are radially oppositely arranged on the framework, and the tail end of the second detection winding is connected with the head end of the fourth detection winding; the head end of the first detection winding of the detection device is connected with the head end of the second detection winding and then connected to a common input end of the signal processing circuit, the tail end of the third detection winding of the detection device is connected to a second input end of the signal processing circuit, and the tail end of the fourth detection winding of the detection device is connected to a first input end of the signal processing circuit; and the output end of the signal processing circuit is connected with the input end of the central controller.

The signal processing circuit is composed of operation amplifiers A1-A2, resistors R1-R8 and a capacitor C; one end of the resistor R1 forms a first input end of the signal processing circuit, one end of the resistor R2 forms a second input end of the signal processing circuit, and one end of the resistor R3 forms a common input end of the signal processing circuit after being connected with a signal common point; the other end of the resistor R1 is connected with the anti-phase input end of the operation amplifier A1; the other ends of the resistor R2 and the resistor R3 are simultaneously connected with the in-phase input end of the operation amplifier A1; and one end of the resistor R4 is connected with the anti-phase input end of the operation amplifier A1, and the other end of the resistor R4 is connected with the output end of the operation amplifier A1; the output end of the operation amplifier A1 is connected with one end of the resistor R5, and the other end of the resistor R5 is connected with one end of the capacitor C and one end of the resistor R6; the other end of the capacitor C and one end of the resistor R7 are simultaneously connected with the signal common point, and the other end of the resistor R7 is connected with the in-phase input end of the operation amplifier A2; the other end of the resistor R6 is connected with the anti-phase input end of the operation amplifier A2; one end of the resistor R8 is connected with the anti-phase input end of the operation amplifier A2, and the other end of the resistor R8 is connected with the output end of the operation amplifier A2; and the output end of the operation amplifier A2 forms the output end of the signal processing circuit.

In the signal processing circuit, the resistors R1 and R2 have the same resistance, the resistors R3 and R4 have the same resistance, the resistors R5 and R6 have the same resistance, and the resistor $R7 = \dfrac{2 \times R5 \times R8}{2 \times R5 + R8}$.

The framework of the detection device is made of non-magnetic conductive insulation material.

The automatic anastigmatic method for an electron gun realized by the automatic anastigmatic electron gun comprises the following steps:

Step 1: initialization: setting the initial value of the preferred exciting current control data $D_{Rmin}$ of the first anastigmatic winding, setting the initial value of the preferred exciting current control data $D_{Tmin}$ of the second anastigmatic winding, and setting the initial value of the deviation of control $\Delta D_{RT}$; setting the reduction coefficient $\lambda$ of the deviation of control $\Delta D_{RT}$, wherein $0 < \lambda$ G 1; setting a pulse electron beam control voltage signal $U_{BS}$ and duration time $\tau$; setting a sampling period $\mu$; and setting an iterative threshold $\eta$, wherein $\eta$ is an integer which is larger than and equal to 1.

Step 2: seeking the original integrated data of electron beam spot morphology in the state of the anastigmatic device without exciting current by test; i.e.:

Starting electron beam machining equipment, and setting the exciting current control data $D_R$ of the first anastigmatic winding and the exciting current control data $D_T$ of the second anastigmatic winding to 0 by the central controller so that the exciting current of the anastigmatic device is 0; and outputting a pulse electron beam control voltage signal $U_{BS}$ by the central controller, sampling an output voltage signal $U_A$ of the signal processing circuit at the sampling period $\mu$ within the duration time $\tau$ of the pulse electron beam control voltage signal $U_{BS}$, and obtaining the maximum absolute value $D_{Amax}$ and the average absolute value $\overline{D}_A$ of the sampled data of the output voltage signal $U_A$; and then calculating the current integrated data Dz of electron beam spot morphology based on the maximum absolute value $D_{Amax}$ and the average absolute value $\overline{D}_A$, and denoting as $D_{Zmin}(0)$.

Step 3: seeking the preferred exciting current control data $D_{Rmin}$ of the first anastigmatic winding by test; i.e.:

Step 3.1: setting the exciting current control data $D_R$ of the first anastigmatic winding to $D_{Rmin} + \Delta D_{RT}$ and the exciting current control data $D_T$ of the second anastigmatic winding to $D_{Tmin}$ by the central controller, and changing the exciting current of the anastigmatic device; and outputting a pulse electron beam control voltage signal $U_{BS}$ by the central controller, sampling an output voltage signal $U_A$ of the signal processing circuit at the sampling period $\mu$ within the duration time $\tau$ of the pulse electron beam control voltage signal $U_{BS}$, and obtaining the maximum absolute value $D_{Amax}$ and the average absolute value $\overline{D}_A$ of the sampled data of the output voltage signal $U_A$; and then calculating the current integrated data Dz of electron beam spot morphology based on the maximum absolute value $D_{Amax}$ and the average absolute value $\overline{D}_A$, and denoting as $D_{Zmin}(1)$;

Step 3.2: setting the exciting current control data $D_R$ of the first anastigmatic winding to $D_{Rmin} - \Delta D_{RT}$ and the exciting current control data $D_T$ of the second anastigmatic winding to $D_{Tmin}$ by the central controller, and changing the exciting current of the anastigmatic device; and outputting a pulse electron beam control voltage signal $U_{BS}$ by the central controller, sampling an output voltage signal $U_A$ of the signal processing circuit at the

sampling period $\mu$ within the duration time $\tau$ of the pulse electron beam control voltage signal $U_{BS}$, and obtaining the maximum absolute value $D_{Amax}$ and the average absolute value $\overline{D}_A$ of the sampled data of the output voltage signal $U_A$; and then calculating the current integrated data Dz of electron beam spot morphology based on the maximum absolute value $D_{Amax}$ and the average absolute value $\overline{D}_A$, and denoting as $D_{Zmin}(2)$;

Step 3.3: comparing the integrated data $D_{Zmin}(0)$, $D_{Zmin}(1)$ and $D_{Zmin}(2)$ of electron beam spot morphology by the central controller:

> If $D_{Zmin}(0)$ is the minimum, assigning the value of $D_{Zmin}(0)$ to $D_{Zmin}(3)$, and keeping $D_{Rmin}$ unchanged;
> If $D_{Zmin}(1)$ is the minimum, assigning the value of $D_{Zmin}(1)$ to $D_{Zmin}(3)$, and assigning the value of $D_{Rmin}+\Delta D_{Rmin}$ to $D_{Rmin}$;
> If Dzmin(2) is the minimum, assigning the value of $D_{Zmin}(2)$ to $D_{Zmin}(3)$, and assigning the value of $D_{Rmin}-\Delta D_{RT}$ to $D_{Rmin}$.

Step 4: seeking the preferred exciting current control data $D_{Tmin}$ of the second anastigmatic winding by test; i.e.:

> Step 4.1: setting the exciting current control data $D_R$ of the first anastigmatic winding to $D_{Rmin}$ and the exciting current control data $D_T$ of the second anastigmatic winding to $D_{Tmin}+\Delta D_{TR}$ by the central controller, and changing the exciting current of the anastigmatic device; and outputting a pulse electron beam control voltage signal $U_{BS}$ by the central controller, sampling an output voltage signal $U_A$ of the signal processing circuit at the sampling period $\mu$ within the duration time $\tau$ of the pulse electron beam control voltage signal $U_{BS}$, and obtaining the maximum absolute value $D_{Amax}$ and the average absolute value $\overline{D}_A$ of the sampled data of the output voltage signal $U_A$; and then calculating the current integrated data Dz of electron beam spot morphology based on the maximum absolute value $D_{Amax}$ and the average absolute value $\overline{D}_A$, and denoting as $D_{Zmin}(4)$;
> Step 4.2: setting the exciting current control data $D_R$ of the first anastigmatic winding to $D_{Rmin}$ and the exciting current control data $D_T$ of the second anastigmatic winding to $D_{Tmin}-\Delta D_{TR}$ by the central controller, and changing the exciting current of the anastigmatic device; and outputting a pulse electron beam control voltage signal $U_{BS}$ by the central controller, sampling an output voltage signal $U_A$ of the signal processing circuit at the sampling period $\mu$ within the duration time $\tau$ of the pulse electron beam control voltage signal $U_{BS}$, and obtaining the maximum absolute value $D_{Amax}$ and the average absolute value $\overline{D}_A$ of the sampled data of the output voltage signal $U_A$; and then calculating the current integrated data Dz of electron beam spot morphology based on the maximum absolute value $D_{Amax}$ and the average absolute value $\overline{D}_A$, and denoting as Dzmin(5);
> Step 4.3: comparing the integrated data $D_{Zmin}(3)$, $D_{Zmin}(4)$ and $D_{Zmin}(5)$ of electron beam spot morphology by the central controller:

>> If Dzmin(3) is the minimum, assigning the value of $D_{Zmin}(3)$ to $D_{Zmin}(6)$, and keeping $D_{Tmin}$ unchanged;
>> If Dzmin(4) is the minimum, assigning the value of $D_{Zmin}(4)$ to $D_{Zmin}(6)$, and assigning the value of $D_{Tmin}+\Delta D_{RT}$ to $D_{Tmin}$;
>> If Dzmin(5) is the minimum, assigning the value of $D_{Zmin}(5)$ to Dzmin(6), and assigning the value of $D_{Tmin}-\Delta D_{RT}$ to $D_{Tmin}$.

Step 5: judging whether the integrated data reaches the minimum value; i.e.:
Comparing the integrated data $D_{Zmin}(6)$ and $D_{Zmin}(0)$ of electron beam spot morphology by the central controller:

> If $D_{Zmin}(6) < D_{Zmin}(0)$, first setting the end mark K to 0; and then assigning the value of $D_{Zmin}(6)$ to $D_{Zmin}(0)$, and after assigning the value of $\lambda \times \Delta D_{RT}$ to $\Delta D_{RT}$, returning to step 3;
> If $D_{Zmin}(6) \wedge D_{Zmin}(0)$, first adding 1 to the end mark K; and then further judging whether the end mark K is less than $\eta$:

>> If yes, keeping $D_{Zmin}(0)$ unchanged, assigning the value of $\lambda \times \Delta D_{RT}$ to $\Delta D_{RT}$, and returning to step 3;
>> Otherwise, storing the preferred exciting current control data $D_{Rmin}$ of the first anastigmatic winding finally obtained in the above process as the final exciting current control data $D_R$ of the first anastigmatic winding, and storing the preferred exciting current control data $D_{Tmin}$ of the second anastigmatic winding as the final exciting current control data $D_T$ of the second anastigmatic winding, thereby completing the automatic anastigmatic test of the electron gun.

In step 1, the initial value of the preferred exciting current control data $D_{Rmin}$ of the first anastigmatic winding is set to 0, the preferred exciting current control data $D_{Tmin}$ of the second anastigmatic winding is set to 0, and the initial value of the deviation of control $\Delta D_{RT}$ of the exciting current control data of the first anastigmatic winding and the second anastigmatic winding is set to $0.5 \times D_{RTM}$, wherein $D_{RTM}$ is the threshold of the anastigmatic windings, i.e., $-D_{RTM} \leq D_R \leq D_{RTM}$, $-D_{RTM} \leq D_T \leq D_{RTM}$.

Within the duration time $\tau$ of a pulse electron beam control voltage signal $U_{BS}$, n sampled data of the output voltage signal $U_A$ of the signal processing circuit are $D_{A1}$, $D_{A2}$, ..., $D_{An}$, and for the sampled data:
The maximum absolute value $D_{Amax}$ is:

$$D_{Amax} = max[|D_{A1}|, |D_{A2}|, ..., |D_{An}|]$$

The average absolute value $\overline{D}_A$ is:

$$\overline{D}_A = \frac{|D_{A1}| + |D_{A2}| + \cdots + |D_{An}|}{n}$$

wherein $n \approx \dfrac{\tau}{\mu}$ , $\tau$ is the duration time of the pulse electron beam control voltage signal $U_{BS}$, and $\mu$ is the sampling period.

The integrated data Dz of the electron beam spot morphology is:

$$D_Z = \alpha \overline{D}_A + (1 - \alpha)D_{Amax}$$

wherein $D_{Amax}$ and $\overline{D}_A$ are respectively the maximum absolute value and the average absolute value of the sampled data of the output voltage signal $U_A$ of the signal processing circuit within the duration time $\tau$ of a pulse electron beam control voltage signal $U_{BS}$, $\alpha$ is the given weighted value of the average absolute value $\overline{D}_A$, and $0 \leq \alpha \leq 1$.

Compared with the prior art, the automatic anastigmatic electron gun based on the non-contact detecting element for electron beam spot morphology of the present invention uses the actual value of the electron beam during machining as the value of the electron beam during correction of the electron beam spot morphology, and automatically seeks the exciting current of the windings of the anastigmatic device corresponding to the optimum electron beam spot morphology according to the detection information of the electron beam spot morphology so as to achieve the purpose of improving the effect of correcting the electron beam spot morphology.

**Description of Drawings**

Fig. 1 is a structural schematic diagram of an automatic anastigmatic electron gun provided by the present invention;
Fig. 2 is a structural schematic diagram of a detection device in Fig. 1;
Fig. 3 is a schematic diagram of a signal processing circuit in Fig. 1;
Fig. 4 is a flow chart of an automatic anastigmatic method for an electron gun provided by the present invention;
Fig. 5 is a diagram of an automatic anastigmatic signal of an electron gun.

Numerals in the figures: 1 - central controller, 2 - electronic source power supply, 3 - drive power supply, 4 - signal processing circuit, 5 - electron beam generator, 6 - anastigmatic device, 7 - focusing device, 8 - detection device, 81 - first detection winding, 82 - second detection winding, 83 - third detection winding, 84 - fourth detection winding, 85 - framework, 9 - electron beam, 10 - workpiece, and 11 - electron gun body.

**Detailed Description**

To make the purpose, the technical solution and the advantages of the present invention more clear, the present invention will be further described below in detail in combination with the specific embodiment and with reference to the accompanying drawings. It should be explained that the directional terms such as "upper", "lower", "middle", "left", "right", "front" and "back" mentioned in the embodiments are only used for convenience in referring to the accompanying drawings. Therefore, the used directions are only used for illustrating the present invention but not used for limiting the protection scope of the present invention.

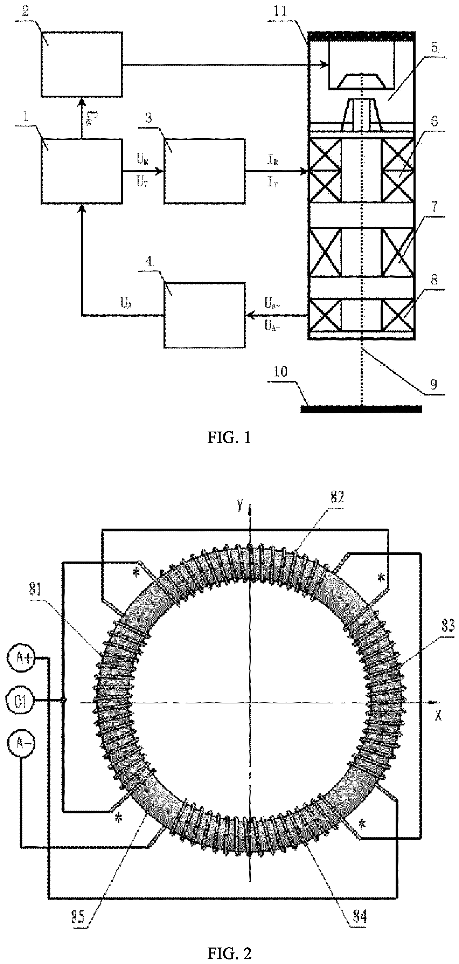

As shown in Fig. 1, an automatic anastigmatic electron gun is mainly composed of a central controller 1, an electronic source power supply 2, a drive power supply 3, a signal processing circuit 4, an electron beam generator 5, an anastigmatic device 6, a focusing device 7 and a detection device 8.

For the electron beam generator 5: a cathode power supply heats the cathode to saturation emission, an electronic accelerating power supply generates an accelerating field between the cathode and the anode, a cathode-emitted electron beam 9 is ejected from an anode hole under the action of the accelerating field, and the size of the electron beam 9 is controlled by grid bias voltage. The electron beam 9 emitted by the electron beam generator 5 is incident on the workpiece 10.

The anastigmatic device 6: is composed of a first anastigmatic winding (i.e., R-phase winding) and a second anastigmatic winding (i.e., T-phase winding). The first anastigmatic winding and the second anastigmatic winding form a structure with a plurality of pairs of axisymmetrical magnetic poles. The anastigmatic device 6 of the present invention can continue to use the existing anastigmatic device 6. The first anastigmatic winding and the second anastigmatic winding are connected to the output end of the drive power supply 3, and the anastigmatic device 6 is installed between the anode of the electron gun and the focusing device 7. When the electron beam 9 passes through the anastigmatic device 6, the non-uniform magnetic field in the anastigmatic device 6 acts on the envelope of the electron beam 9 in multiple directions, thereby changing the morphology of the electron beam 9 spot.

The focusing device 7: is an essential component of the electron gun and is used for adjusting the axial position of the focus of the electron beam 9 spot.

The detection device 8: is composed of a first detection winding 81, a second detection winding 82, a third detection winding 83, a fourth detection winding 84 and a framework 85, as shown in Fig. 2. The framework 85 has an axisymmetrical ring structure and is made of non-magnetic conductive insulation material. The first detection winding 81, the second detection winding 82, the third detection winding 83 and the fourth detection winding 84 all have N turns and the same wire diameter. The first detection winding 81, the second detection winding 82, the third detection winding 83 and the fourth detection winding 84 are wound around the framework 85 and evenly and symmetrically distributed, the axes of the first detection winding 81 and the third detection winding 83 are in the x-axis, and the tail end of the first detection winding 81 is connected with the head end of the third detection winding 83. The axes of the second detection winding 82 and the fourth detection winding 84 are in the vertical y-axis, and the tail end of the second detection winding 82 is connected with the head end of the fourth detection winding 84. The head end of the first detection winding 81 is connected with the head end of the second detection winding 82 and then connected to a common input end C1 of the signal processing circuit 4, the tail end of the third detection winding 83 is connected to a second input end A+ of the signal processing circuit 4, and the tail end of the fourth detection winding 84 is connected to a first input end A- of the signal processing circuit 4. The detection device 8 is installed at the electron beam 9 outlet end of the electron gun. When the pulse electron beam 9 passes through the detection device 8, the space charge current formed by the electron beam 9 generates a variation magnetic field which senses induced electromotive forces $e_1$, $e_2$, $e_3$ and $e_4$ respectively in the first detection winding 81, the second detection winding 82, the third detection winding 83 and the fourth detection

$$e_i(t) = N \frac{d\phi_i}{dt}$$

winding 84, i.e., (i=1, 2, 3, 4, and $\varphi_i$ is the magnetic flux passing through the $i^{th}$ detection winding), the induced electromotive forces of the first detection winding 81 and the third detection winding 83 are superposed into a voltage signal $U_{A+}$($U_{A+}=e_1+e_3$), and the induced electromotive forces of the second detection winding 82 and the fourth detection winding 84 are superposed into a voltage signal $U_{A-}$($U_{A-}=e_2+e_4$). If $\varphi_1=\varphi_2=\varphi_3=\varphi_4$ when the envelope of the electron beam 9 has an axisymmetrical shape and passes through the center of the detection device 8, $e_1=e_2=e_3=e_4$ and $U_{A+}=U_{A-}$; if the electron beam 9 has a non-axisymmetrical shape, $U_{A+} \neq U_{A-}$; and if the difference between $U_{A+}$ and $U_{A-}$ is minimized by adjusting the exciting current $I_R$ and $I_T$ of the anastigmatic device 6, the electron beam 9 spot is judged to be in the optimum correction state.

The central controller 1: is used as the master control device of the electron beam 9 machining equipment. The central controller 1 converts the control data $D_{BS}$ of the electron beam 9 to a voltage signal $U_{BS}$ through D/A conversion, and the voltage signal $U_{BS}$ is transmitted to the control input end of a regulating circuit of a grid bias power supply of the electronic source power supply 2; the central controller 1 converts the exciting current control data $D_R$ and $D_T$ of the anastigmatic device 6 respectively to a voltage signal $U_R$ and a voltage signal $U_T$ through D/A conversion, and the voltage signal $U_R$ and the voltage signal $U_T$ are transmitted to the control input end of the drive power supply 3; the central controller 1 receives the output voltage signal $U_A$ of the signal processing circuit 4, and converts the voltage signal $U_A$ to the sampled data $D_A$ through A/D conversion; the central controller 1 changes the amplitude and the pulse duration time $\tau$ of the voltage signal $U_{BS}$ by setting the control data $D_{BS}$ of the electron beam 9 to realize control on the pulse electron beam 9; the central controller 1 samples the voltage signal $U_A$ at a high speed within the duration time $\tau$ of the pulse electron beam control signal $U_{BS}$, then determines the maximum absolute value $D_{Amax}$ of the sampled data $D_A$ of the voltage signal $U_A$ and calculates the average absolute value data $\overline{D}_A$ of the sampled data $D_A$ of the sampled data $D_A$, and finally calculates the integrated data $D_z = \alpha \overline{D}_A + (1 - \alpha)D_{Amax}$ of electron beam spot morphology, wherein $0 \le \alpha \le 1$; and the central controller 1 calculates the integrated data Dz of the electron beam spot morphology by changing the R-phase and T-phase exciting current control data $D_R$ and $D_T$ of the anastigmatic device 6, and when the integrated data Dz reaches the minimum value, the exciting current control data $D_R$ and $D_T$ of the anastigmatic device 6 are operational data.

The electronic source power supply 2: comprises an electronic accelerating power supply, a cathode heating power supply and a grid bias power supply. The electronic accelerating power supply adopts voltage stabilization control, the positive output end of the electronic accelerating power supply is connected with the anode of the electron beam generator 5 and grounded, the negative output end of the electronic accelerating power supply, the positive output end of the grid bias power supply and one output end of the cathode heating power supply are connected, the output of the cathode heating power supply is connected to the cathode of the electron beam generator 5, and the negative output end of the grid bias power supply is connected to the grid of the electron beam generator 5; and the grid bias power supply is used for adjusting the size of the electron beam 9, the control input signal of the regulating circuit of the grid bias power supply is a signal $U_{BS}$ from the central controller 1, and the regulating circuit of the grid bias power supply automatically adjusts the output voltage of the grid bias power supply so that the electron beam 9 varies with the signal Uss.

The drive power supply 3: is composed of two current amplifying circuits with the same structure, wherein the input control signal of one circuit is a voltage signal $U_R$ from the central controller 1, and the current $I_R$ directly proportional to the voltage signal $U_R$ is output to the first anastigmatic winding of the anastigmatic device 6; and the input control signal of the other circuit is a voltage signal $U_T$ from the central controller 1, and the current $I_T$ directly proportional to the voltage signal $U_T$ is output to the second anastigmatic winding of the anastigmatic device 6.

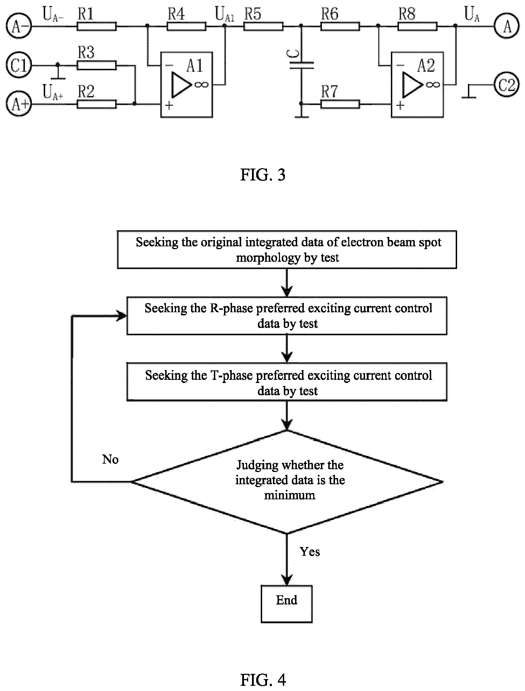

The signal processing circuit 4: is composed of operation amplifiers A1-A2, resistors R1-R8 and a capacitor C, as shown in Fig. 3. One end of the resistor R1 forms a first input end A- of the signal processing circuit 4, one end of the resistor R2 forms a second input end A+ of the signal processing circuit 4, and one end of the resistor R3 is connected with a signal common point C2 and forms a common input end C1 of the signal processing circuit 4; the other end of the resistor R1 is connected with the anti-phase input end of the operation amplifier A1; the other end of the resistor R2 and the other end of the resistor R3 are simultaneously connected with the in-phase input end of the operation amplifier A1; and one end of the resistor R4 is connected with the anti-phase input end of the operation amplifier A1, and the other end of the resistor R4 is connected with the output end of the operation amplifier A1. the output end of the operation amplifier A1 is connected with one end of the resistor R5, and the other end of the resistor R5 is connected with one end of the capacitor C and one end of the resistor R6; the other end of the capacitor C is connected with the signal common point C2, one end of the resistor R7 is connected with the in-phase input end of the operation amplifier A2, and the other end of the resistor R7 is connected with the signal common point C2; the other end of the resistor R6 is connected with the anti-phase input end of the operation amplifier A2; one end of the resistor R8 is connected with the anti-phase input end of the operation amplifier A2, and the other end of the resistor R8 is connected with the output end of the operation amplifier A2; and the output end of the operation amplifier A2 forms the output end A of the signal processing circuit 4, and the output end of the signal common point of the signal processing circuit 4 is a C2 end. The operation amplifier A1, the resistor R1, the resistor R2, the resistor R3 and the resistor R4 form a differential amplification circuit, wherein R1=R2, R3=R4, and $\dfrac{U_{A1}}{U_{A+} - U_{A-}} = \dfrac{R3}{R4}$ . The operation amplifier A2, the resistor R5, the resistor R6, the resistor R7, the resistor R8 and the capacitor C form an anti-phase filter shaping circuit, wherein R5=R6,

$R7 = \dfrac{2 \times R5 \times R8}{2 \times R5 + R8}$ , the input of the differential amplification circuit is connected with the output of the detection device 8, the input signal of the filter shaping circuit is the output voltage signal $U_{A1}$ of the differential amplification circuit, and the transfer function of the filter shaping circuit is $\dfrac{U_A(s)}{U_{A1}(s)} = -\dfrac{R8}{2 \times R5} \times \dfrac{1}{(0.5 \times R5 \times C)\,s + 1}$ , wherein

s is the complex variable of the transfer function, and the output voltage signal $U_A$ of the filter shaping circuit is transmitted to the central controller 1.

The automatic anastigmatic method for an electron gun realized by the automatic anastigmatic electron gun, as shown in Fig. 4, comprises the following steps:

Step 1: seeking the original integrated data of electron beam spot morphology by test;

Step 11: initialization:

Defining the data sampled for n ($n \geq 10$) times from the output voltage signal $U_A$ of the signal processing circuit 4 at the sampling period $\mu$ within the duration time $\tau$ of the pulse electron beam control signal $U_{BS}$ with the amplitude of $B_m$ as $D_{A1}$, $D_{A2}$, ..., $D_{An}$; the maximum absolute value of the data sampled for n times is $D_{Amax}$, wherein $D_{Amax}=max[|D_{A1}|,|D_{A2}|,...,|D_{An}|]$; and the average absolute value of the data sampled for n times is $\overline{D}_A$, wherein

$$\overline{D}_A = \frac{\left|D_{A1}\right| + \left|D_{A2}\right| + \cdots + \left|D_{An}\right|}{n}.$$

Defining the integrated data $D_z= \alpha \overline{D}_A + (1 - \alpha)D_{Amax}$ of the electron beam spot morphology, wherein $\alpha$ is the weighted value of $\overline{D}_A$ ($0 \leq \alpha \leq 1$).

Defining the preferred value of the integrated data Dz of the electron beam spot morphology as $D_{Zmin}$, and the R-phase and T-phase preferred exciting current control data of the anastigmatic device 6 corresponding to Dzmin respectively as $D_{Rmin}$ and Dimin.

Setting the domains of definition of the R-phase and T-phase exciting current control data $D_R$ and $D_T$ of the anastigmatic device 6 as $-D_{RTM} \leq D_R \leq D_{RTM}$ and $-D_{RTM} \leq D_T \leq D_{RTM}$.

At the beginning, setting the R-phase and T-phase preferred exciting current control data $D_{Rmin}$ and $D_{Tmin}$ of the anastigmatic device 6 to 0, and setting the deviation of control $\Delta D_{RT}$ of the R-phase and T-phase exciting current control data of the anastigmatic device 6 to $0.5 \times D_{RTM}$.

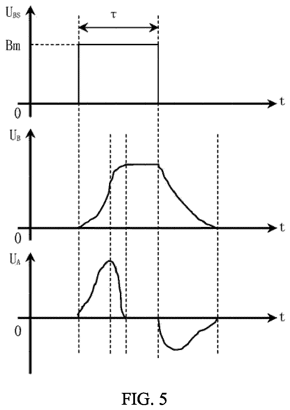

Step 12: starting electron beam machining equipment, assigning 0 to the R-phase exciting current control data $D_R$ by the central controller 1, and assigning 0 to the T-phase exciting current control data $D_T$ by the central controller 1, i.e., the exciting current control voltage signals $U_R$ and $U_T$ of the anastigmatic device 6 output by the central controller 1 are respectively 0. When the central controller 1 outputs a pulse electron beam control voltage signal $U_{BS}$, the voltage signal of the electron beam 9 flow passing through the detection device 8 is $U_B$, the output voltage signal of the signal processing circuit 4 is $U_A$, and the waveforms of the voltage signals $U_{BS}$, $U_B$ and $U_A$ are shown in Fig. 5.

Step 13: sampling the voltage signal $U_A$ for n times by the central controller 1 at the sampling period $\mu$ within the duration time $\tau$ of the pulse electron beam control voltage signal $U_{BS}$, and storing the sampled data respectively as $D_{A1}$, $D_{A2}$, ..., $D_{An}$.

Step 14: after sampling by the central controller 1, calculating and storing the maximum absolute value of $D_{A1}$, $D_{A2}$, ..., $D_{An}$ as $D_{Amax}$ by the central controller 1, calculating and storing the average absolute value of $D_{A1}$, $D_{A2}$, ..., $D_{An}$ as $\overline{D}_A$ by the central controller 1, and calculating and storing the integrated data of the electron beam spot morphology as $D_{Zmin}(0)$ by the central controller 1.

Step 2: seeking the R-phase (first anastigmatic winding) preferred exciting current control data $D_{Rmin}$ by test;

Step 21: assigning the value of $D_{Rmin}+\Delta D_{RT}$ to the R-phase exciting current control data $D_R$ and the value of $D_{Tmin}$ to the T-phase exciting current control data $D_T$ by the central controller 1, and changing the exciting current of the anastigmatic device 6.

Step 22: outputting a pulse electron beam control voltage signal $U_{BS}$ by the central controller 1, sampling the voltage signal $U_A$ for n times by the central controller 1 at the sampling period $\mu$ within the duration time $\tau$ of the pulse electron beam control voltage signal $U_{BS}$, and storing the sampled data respectively as $D_{A1}$, $D_{A2}$, ..., $D_{An}$.

Step 23: after sampling by the central controller 1, determining and storing the maximum absolute value of $D_{A1}$, $D_{A2}$, ..., $D_{An}$ as $D_{Amax}$ by the central controller 1, calculating and storing the average absolute value of $D_{A1}$, $D_{A2}$, ..., $D_{An}$ as $\overline{D}_A$ by the central controller 1, and calculating and storing the integrated data of the electron beam spot morphology as $D_{Zmin}(1)$ by the central controller 1.

Step 24: assigning the value of $D_{Rmin}-\Delta D_{RT}$ to the R-phase exciting current control data $D_R$ and the value of $D_{Tmin}$ to the T-phase exciting current control data $D_T$ by the central controller 1, and changing the exciting current of the anastigmatic device 6.

Step 25: outputting a pulse electron beam control voltage signal $U_{BS}$ by the central controller 1, sampling the voltage signal $U_A$ for n times by the central controller 1 at the sampling period $\mu$ within the duration time $\tau$ of the pulse electron beam control voltage signal $U_{BS}$, and storing the sampled data respectively as $D_{A1}$, $D_{A2}$, ..., $D_{An}$.

Step 26: after sampling by the central controller 1, calculating and storing the maximum absolute value of $D_{A1}$, $D_{A2}$, ..., $D_{An}$ as $D_{Amax}$ by the central controller 1, calculating and storing the average absolute value of $D_{A1}$, $D_{A2}$, ..., $D_{An}$ as $\overline{D}_A$ by the central controller 1, and calculating and storing the integrated data of the electron beam spot morphology as $D_{Zmin}(2)$ by the central controller 1.

Step 27: comparing the three data $D_{Zmin}(0)$, $D_{Zmin}(1)$ and $D_{Zmin}(2)$ by the central controller 1:

If $D_{Zmin}(0)$ is the minimum, assigning the value of $D_{Zmin}(0)$ to $D_{zmin}(3)$, and keeping $D_{Rmin}$ unchanged;
If $D_{Zmin}(1)$ is the minimum, assigning the value of $D_{Zmin}(1)$ to $D_{Zmin}(3)$, and assigning the value of $D_{Rmin}+\Delta D_{Rmin}$ to $D_{Rmin}$;
If $D_{Zmin}(2)$ is the minimum, assigning the value of $D_{Zmin}(2)$ to $D_{Zmin}(3)$, and assigning the value of $D_{Rmin}-\Delta D_{RT}$ to $D_{Rmin}$.

Step 3: seeking the T-phase (second anastigmatic winding) preferred exciting current control data $D_{Tmin}$ by test;
Step 31: assigning the value of $D_{Rmin}$ to the R-phase exciting current control data $D_R$ and the value of $D_{Tmin}+\Delta D_{RT}$ to the T-phase exciting current control data $D_T$ by the central controller 1, and changing the exciting current of the anastigmatic device 6.

Step 32: outputting a pulse electron beam control voltage signal $U_{BS}$ by the central controller 1, sampling the voltage signal $U_A$ for n times by the central controller 1 at the sampling period $\mu$ within the duration time $\tau$ of the pulse electron beam control voltage signal $U_{BS}$, and storing the sampled data respectively as $D_{A1}$, $D_{A2}$, ..., $D_{An}$.

Step 33: after sampling by the central controller 1, determining and storing the maximum absolute value of $D_{A1}$, $D_{A2}$, ..., $D_{An}$ as $D_{Amax}$ by the central controller 1, calculating and storing the average absolute value of $D_{A1}$, $D_{A2}$, ..., $D_{An}$ as $\overline{D}_A$ by the central controller 1, and calculating and storing the integrated data of the electron beam spot morphology as $D_{Zmin}(4)$ by the central controller 1.

Step 34: assigning the value of $D_{Rmin}$ to the R-phase exciting current control data $D_R$ and the value of $D_{Tmin}-\Delta D_{RT}$ to the T-phase exciting current control data $D_T$ by the central controller 1, and changing the exciting current of the anastigmatic device 6.

Step 35: outputting a pulse electron beam control voltage signal $U_{BS}$ by the central controller 1, sampling the voltage signal $U_A$ for n times by the central controller 1 at the sampling period $\mu$ within the duration time $\tau$ of the pulse electron beam control voltage signal $U_{BS}$, and storing the sampled data respectively as $D_{A1}$, $D_{A2}$, ..., $D_{An}$.

Step 36: after sampling by the central controller 1, determining and storing the maximum absolute value of $D_{A1}$, $D_{A2}$, ..., $D_{An}$ as $D_{Amax}$ by the central controller 1, calculating and storing the average absolute value of $D_{A1}$, $D_{A2}$, ..., $D_{An}$ as $\overline{D}_A$ by the central controller 1, and calculating and storing the integrated data of the electron beam spot morphology as $D_{Zmin}(5)$ by the central controller 1.

Step 37: comparing the three data $D_{Zmin}(3)$, $D_{zmin}(4)$ and $D_{Zmin}(5)$ by the central controller 1:

If $D_{zmin}(3)$ is the minimum, assigning the value of $D_{Zmin}(3)$ to $D_{zmin}(6)$, and keeping $D_{Tmin}$ unchanged;
If $D_{Zmin}(4)$ is the minimum, assigning the value of $D_{Zmin}(4)$ to $D_{Zmin}(6)$, and assigning the value of $D_{Tmin}+\Delta D_{RT}$ to $D_{Tmin}$;
If $D_{zmin}(5)$ is the minimum, assigning the value of $D_{Zmin}(5)$ to $D_{Zmin}(6)$, and assigning the value of $D_{Tmin}-\Delta D_{RT}$ to $D_{Tmin}$.

Step 4: judging the minimum of the integrated data

Comparing the two data $D_{Zmin}(6)$ and $D_{Zmin}(0)$ by the central controller 1:

If $D_{Zmin}(6) < D_{Zmin}(0)$, first setting the end mark K to 0; and then assigning the value of $D_{Zmin}(6)$ to $D_{Zmin}(0)$, and after assigning the value of $0.5\times\Delta D_{RT}$ to $\Delta D_{RT}$, returning to step 2;
If $D_{Zmin}(6) \geq D_{Zmin}(0)$, first adding 1 to the end mark K; and then further judging whether the end mark K is less than 2:

If yes, keeping $D_{Zmin}(0)$ unchanged, assigning the value of $0.5\times\Delta D_{RT}$ to $\Delta D_{RT}$, and returning to step 2;
Otherwise, storing the R-phase and T-phase preferred exciting current control data $D_{Rmin}$ and $D_{Tmin}$ of the anastigmatic device 6 finally obtained in the above process, thereby completing the automatic anastigmatic test of the electron gun.

During normal operation of the electron beam machining equipment, the central controller 1 uses the stored data $D_{Rmin}$ and $D_{Tmin}$ respectively as the control data of the exciting current of the first anastigmatic winding and the control data of the exciting current of the second anastigmatic winding.

The system has the following characteristic: a split Rogowski coil is used as the detecting element to realize non-contact detection of electron beam spot morphology in combination with the pulse electron beam technology. The split Rogowski coil uses differential-mode signals as the output and the minimum value of detection signals as the correction target of the anastigmatic device, which simplifies the processing method of detection signals, eliminates the influence of common-mode interference signals, and improves detection sensitivity and precision. The "optimum" exciting current of the anastigmatic device is searched by axes to realize quick search. The weighted values of the amplitude and the average value of the detection signals can reflect the difference of electron beam spot morphology more fully. With the integrated data of the weighted values as the judgment basis, two rounds of search and confirmation of the "optimum" value further improve the reliability and reduce the randomness.

It should be explained that the above embodiments described in the present invention are illustrative but are not intended to limit the present invention, so the present invention is not limited to the above specific embodiments. Other embodiments obtained by those skilled in the art under the enlightenment of the present invention without departing from the scope of the claims shall be considered to belong to the protection scope of the present invention.

**Claims**

1.  An automatic anastigmatic electron gun, comprising a central controller (1), an electronic source power supply (2), a drive power supply (3) and an electron gun body (11);

    an electron beam generator (5), an anastigmatic device (6) and a focusing device (7) are arranged in the electron gun body (11) from top to bottom; and the anastigmatic device (6) comprises anastigmatic windings with two phases, which form a structure with a plurality of pairs of axisymmetrical magnetic poles;
    an electron beam control voltage signal output end of the central controller (1) is connected with a control input end of the electronic source power supply (2), and an output end of the electronic source power supply (2) is connected with the electron beam generator (5); a first anastigmatic control voltage signal output end of the central controller (1) is connected with a first control input end of the drive power supply (3), and a first output end of the drive power supply (3) is connected with a first anastigmatic winding of the anastigmatic device (6); and a second anastigmatic control voltage signal output end of the central controller (1) is connected with a second control input end of the drive power supply (3), and a second output end of the drive power supply (3) is connected with a second anastigmatic winding of the anastigmatic device (6);
    **characterized by** further comprising a detection device (8) and a signal processing circuit (4),
    the detection device (8) is arranged in the electron gun body (11) and located at an electron beam (9) outlet end directly below the focusing device (7); the detection device (8) comprises a framework (85) and four detection windings; the framework (85) has a ring structure of non-magnetic conductive insulation material; the four windings have the same number of turns and the same wire diameter, and are wound around the framework (85) and evenly and symmetrically distributed; a first detection winding (81) and a third detection winding (83) are radially oppositely arranged on the framework (85), and the tail end of the first detection winding (81) is connected with the head end of the third detection winding (83); and a second detection winding (82) and a fourth detection winding (84) are radially oppositely arranged on the framework (85), and the tail end of the second detection winding (82) is connected with the head end of the fourth detection winding (84);
    the head end of the first detection winding (81) of the detection device (8) is connected with the head end of the second detection winding (82) and then connected to a common input end of the signal processing circuit (4), the tail end of the third detection winding (83) of the detection device (8) is connected to a second input end of the signal processing circuit (4), and the tail end of the fourth detection winding (84) of the detection device (8) is connected to a first input end of the signal processing circuit (4); and the output end of the signal processing circuit (4) is connected with the input end of the central controller (1).

2.  The automatic anastigmatic electron gun according to claim 1, **characterized in that** the signal processing circuit (4) is composed of operation amplifiers A1-A2, resistors R1-R8 and a capacitor C;

    one end of the resistor R1 forms the first input end of the signal processing circuit (4), one end of the resistor R2 forms the second input end of the signal processing circuit (4), and one end of the resistor R3 forms the common input end of the signal processing circuit (4) after being connected with a signal common point; the other end of the resistor R1 is connected with an anti-phase input end of the operation amplifier A1; the other ends of the resistor R2 and the resistor R3 are simultaneously connected with the in-phase input end of the operation amplifier A1; and one end of the resistor R4 is connected with the anti-phase input end of the operation amplifier A1, and the other end of the resistor R4 is connected with an output end of the operation amplifier A1; the output end of the operation amplifier A1 is connected with one end of the resistor R5, and the other end of the resistor R5 is connected with one end of the capacitor C and one end of the resistor R6; the other end of the capacitor C and one end of the resistor R7 are simultaneously connected with the signal common point, and the other end of the resistor R7 is connected with an in-phase input end of the operation amplifier A2; the other end of the resistor R6 is connected with an anti-phase input end of the operation amplifier A2; one end of the resistor R8 is connected with the anti-phase input end of the operation amplifier A2, and the other end of the resistor R8 is connected with an output end of the operation amplifier A2; and the output end of the operation amplifier A2 forms the output end of the signal processing circuit (4).

3. The automatic anastigmatic electron gun according to claim 2, **characterized in that** the resistors R1 and R2 have the same resistance, the resistors R3 and R4 have the same resistance, the resistors R5 and R6 have the same resistance, and the resistor $R7 = \dfrac{2 \times R5 \times R8}{2 \times R5 + R8}$.

4. An automatic anastigmatic method for an electron gun according to claim 1, **characterized by** comprising the following steps:

step 1: initialization: setting the initial value of the preferred exciting current control data $D_{Rmin}$ of the first anastigmatic winding, setting the initial value of the preferred exciting current control data $D_{Tmin}$ of the second anastigmatic winding, and setting the initial value of the deviation of control $\Delta D_{RT}$; setting the reduction coefficient $\lambda$ of the deviation of control $\Delta D_{RT}$, wherein $0 < \lambda G 1$; setting a pulse electron beam control voltage signal $U_{BS}$ and duration time $\tau$; setting a sampling period $\mu$; and setting an iterative threshold $\eta$, wherein $\eta$ is an integer which is larger than and equal to 1;

step 2: seeking the original integrated data of electron beam spot morphology in the state of the anastigmatic device (6) without exciting current by test; i.e.:

starting an electron gun, and setting the exciting current control data $D_R$ of the first anastigmatic winding and the exciting current control data $D_T$ of the second anastigmatic winding to 0 by the central controller (1) so that the exciting current of the anastigmatic device (6) is 0; and outputting a pulse electron beam control voltage signal $U_{BS}$ by the central controller (1), sampling an output voltage signal $U_A$ of the signal processing circuit (4) at the sampling period $\mu$ within the duration time $\tau$ of the pulse electron beam control voltage signal $U_{BS}$, and obtaining the maximum absolute value $D_{Amax}$ and the average absolute value $\overline{D}_A$ of the sampled data of the output voltage signal $U_A$; and then calculating the current integrated data Dz of electron beam spot morphology based on the maximum absolute value $D_{Amax}$ and the average absolute value $\overline{D}_A$, and denoting as $D_{Zmin}(0)$.

step 3: seeking the preferred exciting current control data $D_{Rmin}$ of the first anastigmatic winding by test; i.e.:

step 3.1: setting the exciting current control data $D_R$ of the first anastigmatic winding to $D_{Rmin} + \Delta D_{RT}$ and the exciting current control data $D_T$ of the second anastigmatic winding to $D_{Tmin}$ by the central controller (1), and changing the exciting current of the anastigmatic device (6); and outputting a pulse electron beam control voltage signal $U_{BS}$ by the central controller (1), sampling an output voltage signal $U_A$ of the signal processing circuit (4) at the sampling period $\mu$ within the duration time $\tau$ of the pulse electron beam control voltage signal $U_{BS}$, and obtaining the maximum absolute value $D_{Amax}$ and the average absolute value $\overline{D}_A$ of the sampled data of the output voltage signal $U_A$; and then calculating the current integrated data Dz of electron beam spot morphology based on the maximum absolute value $D_{Amax}$ and the average absolute value $\overline{D}_A$, and denoting as $D_{Zmin}(1)$;

step 3.2: setting the exciting current control data $D_R$ of the first anastigmatic winding to $D_{Rmin} - \Delta D_{RT}$ and the exciting current control data $D_T$ of the second anastigmatic winding to $D_{Tmin}$ by the central controller (1), and changing the exciting current of the anastigmatic device (6); and outputting a pulse electron beam control voltage signal $U_{BS}$ by the central controller (1), sampling an output voltage signal $U_A$ of the signal processing circuit (4) at the sampling period $\mu$ within the duration time $\tau$ of the pulse electron beam control voltage signal $U_{BS}$, and obtaining the maximum absolute value $D_{Amax}$ and the average absolute value $\overline{D}_A$ of the sampled data of the output voltage signal $U_A$; and then calculating the current integrated data Dz of electron beam spot morphology based on the maximum absolute value $D_{Amax}$ and the average absolute value $\overline{D}_A$, and denoting as $D_{Zmin}(2)$;

step 3.3: comparing the integrated data $D_{Zmin}(0)$, $D_{Zmin}(1)$ and $D_{Zmin}(2)$ of electron beam spot morphology by the central controller (1):

if $D_{Zmin}(0)$ is the minimum, assigning the value of $D_{Zmin}(0)$ to $D_{Zmin}(3)$, and keeping $D_{Rmin}$ unchanged;
if $D_{Zmin}(1)$ is the minimum, assigning the value of $D_{Zmin}(1)$ to $D_{Zmin}(3)$, and assigning the value of $D_{Rmin}+\Delta D_{RT}$ to $D_{Rmin}$;
if Dzmin(2) is the minimum, assigning the value of $D_{Zmin}(2)$ to $D_{Zmin}(3)$, and assigning the value of $D_{Rmin}-\Delta D_{RT}$ to $D_{Rmin}$;

step 4: seeking the preferred exciting current control data $D_{Tmin}$ of the second anastigmatic winding by test; i.e.:

step 4.1: setting the exciting current control data $D_R$ of the first anastigmatic winding to $D_{Rmin}$ and the exciting current control data $D_T$ of the second anastigmatic winding to $D_{Tmin}+\Delta D_{TR}$ by the central controller (1), and changing the exciting current of the anastigmatic device (6); and outputting a pulse electron beam control voltage signal $U_{BS}$ by the central controller (1), sampling an output voltage signal $U_A$ of the signal processing circuit (4) at the sampling period $\mu$ within the duration time $\tau$ of the pulse electron beam control voltage signal $U_{BS}$, and obtaining the maximum absolute value $D_{Amax}$ and the average absolute value $\overline{D}_A$ of the sampled data of the output voltage signal $U_A$; and then calculating the current integrated data Dz of electron beam spot morphology based on the maximum absolute value $D_{Amax}$ and the average absolute value $\overline{D}_A$, and denoting as $D_{Zmin}(4)$;
step 4.2: setting the exciting current control data $D_R$ of the first anastigmatic winding to $D_{Rmin}$ and the exciting current control data $D_T$ of the second anastigmatic winding to $D_{Tmin}-\Delta D_{TR}$ by the central controller (1), and changing the exciting current of the anastigmatic device (6); and outputting a pulse electron beam control voltage signal $U_{BS}$ by the central controller (1), sampling an output voltage signal $U_A$ of the signal processing circuit (4) at the sampling period $\mu$ within the duration time $\tau$ of the pulse electron beam control voltage signal $U_{BS}$, and obtaining the maximum absolute value $D_{Amax}$ and the average absolute value $\overline{D}_A$ of the sampled data of the output voltage signal $U_A$; and then calculating the current integrated data Dz of electron beam spot morphology based on the maximum absolute value $D_{Amax}$ and the average absolute value $\overline{D}_A$, and denoting as $D_{Zmin}(5)$;
step 4.3: comparing the integrated data Dzmin(3), Dzmin(4) and Dzmin(5) of electron beam spot morphology by the central controller (1):

if $D_{Zmin}(3)$ is the minimum, assigning the value of $D_{Zmin}(3)$ to $D_{Zmin}(6)$, and keeping $D_{Tmin}$ unchanged;
if $D_{Zmin}(4)$ is the minimum, assigning the value of $D_{Zmin}(4)$ to $D_{Zmin}(6)$, and assigning the value of $D_{Tmin}+\Delta D_{RT}$ to $D_{Tmin}$;
if $D_{Zmin}(5)$ is the minimum, assigning the value of $D_{Zmin}(5)$ to $D_{Zmin}(6)$, and assigning the value of $D_{Tmin}-\Delta D_{RT}$ to $D_{Tmin}$;

step 5: judging whether the integrated data reaches the minimum value; i.e.:
comparing the integrated data $D_{Zmin}(6)$ and $D_{Zmin}(0)$ of electron beam spot morphology by the central controller (1):

if $D_{Zmin}(6) < D_{Zmin}(0)$, first setting the end mark K to 0; and then assigning the value of $D_{Zmin}(6)$ to $D_{Zmin}(0)$, and after assigning the value of $\lambda \times \Delta D_{RT}$ to $\Delta D_{RT}$, returning to step 3;
if $D_{Zmin}(6) \geq D_{Zmin}(0)$, first adding 1 to the end mark K; and then further judging whether the end mark K is less than the iterative threshold $\eta$:

if yes, keeping $D_{Zmin}(0)$ unchanged, assigning the value of $\lambda \times \Delta D_{RT}$ to $\Delta D_{RT}$, and returning to step 3;
otherwise, storing the preferred exciting current control data $D_{Rmin}$ of the first anastigmatic winding finally obtained in the above process as the final exciting current control data $D_R$ of the first anastigmatic winding, and storing the preferred exciting current control data $D_{Tmin}$ of the second anastigmatic winding as the final exciting current control data $D_T$ of the second anastigmatic winding, thereby completing the automatic anastigmatic test of the electron gun.

5. The automatic anastigmatic method for an electron gun according to claim 4, **characterized in that** in step 1, the initial value of the preferred exciting current control data $D_{Rmin}$ of the first anastigmatic winding is set to 0, the initial value of the preferred exciting current control data $D_{Tmin}$ of the second anastigmatic winding is set to 0, and the initial value of the deviation of control $\Delta D_{RT}$ of the exciting current control data of the first anastigmatic winding and the second anastigmatic winding is set to $0.5 \times D_{RTM}$, wherein $D_{RTM}$ is the threshold of the anastigmatic windings, i.e., $-D_{RTM} \leq D_R \leq D_{RTM}, -D_{RTM} \leq D_T \leq D_{RTM}$, $D_R$ is the exciting current control data of the first anastigmatic winding, and $D_T$ is the exciting current control data of the second anastigmatic winding.

6. The automatic anastigmatic method for an electron gun according to claim 4, **characterized in that** within the duration time $\tau$ of a pulse electron beam control voltage signal $U_{BS}$, n sampled data of the output voltage signal $U_A$ of the signal processing circuit (4) are $D_{A1}, D_{A2}, ..., D_{An}$, and for the sampled data:

   the maximum absolute value $D_{Amax}$ is:

$$D_{Amax} = max[|D_{A1}|, |D_{A2}|, ..., |D_{An}|]$$

   the average absolute value $\overline{D}_A$ is:

$$\overline{D}_A = \frac{|D_{A1}| + |D_{A2}| + \cdots + |D_{An}|}{n}$$

   wherein $n \approx \dfrac{\tau}{\mu}$, $\tau$ is the duration time of the pulse electron beam control voltage signal $U_{BS}$, and $\mu$ is the sampling period.

7. The automatic anastigmatic method for an electron gun according to claim 5 or 6, **characterized in that** the integrated data Dz of electron beam spot morphology is:

$$D_Z = \alpha \, \overline{D}_A + (1 - \alpha) D_{Amax}$$

   wherein $D_{Amax}$ and $\overline{D}_A$ are respectively the maximum absolute value and the average absolute value of the sampled data of the output voltage signal $U_A$ of the signal processing circuit (4), $\alpha$ is the given weighted value of the average absolute value $\overline{D}_A$, and $0 \leq \alpha \leq 1$.

8. The automatic anastigmatic method for an electron gun according to claim 4, **characterized in that** the iterative threshold $\eta = 2$.

**Patentansprüche**

1. Automatische anastigmatische Elektronenkanone, umfassend eine zentrale Steuerung (1), eine elektronische Quellenstromversorgung (2), eine Antriebsstromversorgung (3) und einen Elektronenkanonengehäuse (11);

   wobei ein Elektronenstrahlgenerator (5), eine anastigmatische Vorrichtung (6) und eine Fokussiervorrichtung (7) in dem Elektronenkanonengehäuse (11) von oben nach unten angeordnet sind; und die anastigmatische Vorrichtung (6) anastigmatische Wicklungen mit zwei Phasen umfasst, die eine Struktur mit einer Vielzahl von Paaren von achsensymmetrischen Magnetpolen bilden;
   ein Elektronenstrahl-Steuerspannungssignal-Ausgangsende der zentralen Steuerung (1) mit einem Steuereingangsende der elektronischen Quellenstromversorgung (2) verbunden ist, und ein Ausgangsende der elektronischen Quellenstromversorgung (2) mit dem Elektronenstrahlgenerator (5) verbunden ist; ein erstes anastigmatisches Steuerspannungssignal-Ausgangsende der zentralen Steuerung (1) mit einem ersten Steuereingangsende der Antriebsstromversorgung (3) verbunden ist und ein erstes Ausgangsende der Antriebsstromversorgung (3) mit einer ersten anastigmatischen Wicklung der anastigmatischen Vorrichtung (6) verbunden ist; und ein zweites anastigmatisches Steuerspannungssignal-Ausgangsende der zentralen Steuerung (1) mit einem zweiten Steuereingangsende der Antriebsstromversorgung (3) verbunden ist und ein zweites Ausgangsende der Antriebsstromversorgung (3) mit einer zweiten anastigmatischen Wicklung der anastigmatischen Vorrichtung (6) verbunden ist;

**dadurch gekennzeichnet, dass** sie ferner eine Erfassungsvorrichtung (8) und eine Signalverarbeitungsschaltung (4) umfasst,

die Erfassungsvorrichtung (8) in dem Elektronenkanonengehäuse (11) angeordnet ist und sich an einem Auslassende des Elektronenstrahls (9) direkt unterhalb der Fokussiervorrichtung (7) befindet; die Erfassungsvorrichtung (8) einen Rahmen (85) und vier Erfassungswicklungen umfasst; der Rahmen (85) eine Ringstruktur aus nichtmagnetischem, leitendem Isoliermaterial aufweist; die vier Wicklungen die gleiche Windungszahl und den gleichen Drahtdurchmesser aufweisen und gleichförmig und symmetrisch um den Rahmen (85) gewickelt sind; eine erste Erfassungswicklung (81) und eine dritte Erfassungswicklung (83) radial gegenüberliegend auf dem Rahmen (85) angeordnet sind, und das hintere Ende der ersten Erfassungswicklung (81) mit dem Kopfende der dritten Erfassungswicklung (83) verbunden ist; und eine zweite Erfassungswicklung (82) und eine vierte Erfassungswicklung (84) radial gegenüberliegend auf dem Rahmen (85) angeordnet sind, und das hintere Ende der zweiten Erfassungswicklung (82) mit dem vorderen Ende der vierten Erfassungswicklung (84) verbunden ist; das Kopfende der ersten Erfassungswicklung (81) der Erfassungsvorrichtung (8) mit dem Kopfende der zweiten Erfassungswicklung (82) verbunden ist und dann mit einem gemeinsamen Eingangsende der Signalverarbeitungsschaltung (4) verbunden ist, das hintere Ende der dritten Erfassungswicklung (83) der Erfassungsvorrichtung (8) mit einem zweiten Eingangsende der Signalverarbeitungsschaltung (4) verbunden ist, und das hintere Ende der vierten Erfassungswicklung (84) der Erfassungsvorrichtung (8) mit einem ersten Eingangsende der Signalverarbeitungsschaltung (4) verbunden ist; und das Ausgangsende der Signalverarbeitungsschaltung (4) mit dem Eingangsende der zentralen Steuerung (1) verbunden ist.

2. Automatische anastigmatische Elektronenkanone nach Anspruch 1, **dadurch gekennzeichnet, dass** die Signalverarbeitungsschaltung (4) aus Operationsverstärkern A1-A2, Widerständen R1-R8 und einem Kondensator C besteht;

ein Ende des Widerstands R1 das erste Eingangsende der Signalverarbeitungsschaltung (4) bildet, ein Ende des Widerstands R2 das zweite Eingangsende der Signalverarbeitungsschaltung (4) bildet, und ein Ende des Widerstands R3 das gemeinsame Eingangsende der Signalverarbeitungsschaltung (4) bildet, nachdem es mit einem gemeinsamen Signalpunkt verbunden wurde; das andere Ende des Widerstands R1 mit einem gegenphasigen Eingangsende des Operationsverstärkers A1 verbunden ist; die anderen Enden des Widerstands R2 und des Widerstands R3 gleichzeitig mit dem gleichphasigen Eingangsende des Operationsverstärkers A1 verbunden sind; und ein Ende des Widerstands R4 mit dem gegenphasigen Eingangsende des Operationsverstärkers A1 verbunden ist und das andere Ende des Widerstands R4 mit einem Ausgangsende des Operationsverstärkers A1 verbunden ist;

das Ausgangsende des Operationsverstärkers A1 mit einem Ende des Widerstands R5 verbunden ist, und das andere Ende des Widerstands R5 mit einem Ende des Kondensators C und einem Ende des Widerstands R6 verbunden ist; das andere Ende des Kondensators C und das eine Ende des Widerstands R7 gleichzeitig mit dem gemeinsamen Signalpunkt verbunden sind, und das andere Ende des Widerstands R7 mit einem phasengleichen Eingangsende des Operationsverstärkers A2 verbunden ist; das andere Ende des Widerstands R6 mit einem gegenphasigen Eingangsende des Operationsverstärkers A2 verbunden ist; ein Ende des Widerstands R8 mit dem gegenphasigen Eingangsende des Operationsverstärkers A2 verbunden ist, und das andere Ende des Widerstands R8 mit einem Ausgangsende des Operationsverstärkers A2 verbunden ist; und der Ausgang des Operationsverstärkers A2 den Ausgang der Signalverarbeitungsschaltung (4) bildet.

3. Automatische anastigmatische Elektronenkanone nach Anspruch 2, **dadurch gekennzeichnet, dass** die Widerstände R1 und R2 den gleichen Widerstand aufweisen, die Widerstände R3 und R4 den gleichen Widerstand aufweisen, die Widerstände R5 und R6 den gleichen Widerstand aufweisen, und der Widerstand

$$R7 = \frac{2 \times R5 \times R8}{2 \times R5 + R8}.$$

4. Automatisches anastigmatisches Verfahren für eine Elektronenkanone nach Anspruch 1, **dadurch gekennzeichnet, dass** es die folgenden Schritte umfasst:

Schritt 1: Initialisierung: Einstellen des Anfangswerts der bevorzugten Erregerstromsteuerdaten $D_{Rmin}$ der ersten anastigmatischen Wicklung, Einstellen des Anfangswerts der bevorzugten Erregerstromsteuerdaten $D_{Tmin}$ der zweiten anastigmatischen Wicklung, und Einstellen des Anfangswerts der Steuerungsabweichung $\Delta D_{RT}$; Einstellen des Reduktionskoeffizienten $\lambda$ der Steuerungsabweichung $\Delta D_{RT}$, wobei $0< \lambda <1$; Einstellen eines gepulsten Elektronenstrahl-Steuerspannungssignals $U_{BS}$ und einer Zeitdauer $\tau$; Einstellen einer Abtastperiode $\mu$; und Einstellen eines iterativen Schwellenwerts $\eta$, wobei $\eta$ eine ganze Zahl ist, die größer als und gleich wie 1 ist;

Schritt 2: Suchen der ursprünglichen integrierten Daten von Elektronenstrahlfleck-Morphologie in dem Zustand der anastigmatischen Vorrichtung (6) ohne Erregerstrom durch Test; d. h.:

Starten einer Elektronenkanone, und Einstellen der Erregerstromsteuerdaten $D_R$ der ersten anastigmatischen Wicklung und der Erregerstromsteuerdaten $D_T$ der zweiten anastigmatischen Wicklung auf 0 durch die zentrale Steuerung (1), sodass der Erregerstrom der anastigmatischen Vorrichtung (6) 0 ist; und Ausgeben eines gepulsten Elektronenstrahl-Steuerspannungssignals $U_{BS}$ durch die zentrale Steuerung (1), Abtasten eines Ausgangsspannungssignals $U_A$ der Signalverarbeitungsschaltung (4) mit der Abtastperiode $\mu$ innerhalb der Zeitdauer $\tau$ des gepulsten Elektronenstrahl-Steuerspannungssignals $U_{BS}$, und Erlangen des maximalen Absolutwerts $D_{Amax}$ und des durchschnittlichen Absolutwerts $\overline{D}_A$ der abgetasteten Daten des Ausgangsspannungssignals $U_A$; und dann Berechnen der aktuellen integrierten Daten Dz von Elektronenstrahlfleck-Morphologie basierend auf dem maximalen Absolutwert $D_{Amax}$ und dem durchschnittlichen Absolutwert $\overline{D}_A$, und Bezeichnen als $D_{Zmin}(0)$;

Schritt 3: Suchen der bevorzugten Erregerstromsteuerdaten $D_{Rmin}$ der ersten anastigmatischen Wicklung durch Test; d. h.:

Schritt 3.1: Einstellen der Erregerstromsteuerdaten $D_R$ der ersten anastigmatischen Wicklung auf $D_{Rmin}+\Delta D_{RT}$ und der Erregerstromsteuerdaten $D_T$ der zweiten anastigmatischen Wicklung auf $D_{Tmin}$ durch die zentrale Steuerung (1), und Ändern des Erregerstroms der anastigmatischen Vorrichtung (6); und Ausgeben eines gepulsten Elektronenstrahl-Steuerspannungssignals $U_{BS}$ durch die zentrale Steuerung (1), Abtasten eines Ausgangsspannungssignals $U_A$ der Signalverarbeitungsschaltung (4) mit der Abtastperiode $\mu$ innerhalb der Zeitdauer $\tau$ des gepulsten Elektronenstrahl-Steuerspannungssignals $U_{BS}$, und Erlangen des maximalen Absolutwerts $D_{Amax}$ und des durchschnittlichen Absolutwerts $\overline{D}_A$ der abgetasteten Daten des Ausgangsspannungssignals $U_A$; und dann Berechnen der aktuellen integrierten Daten Dz von Elektronenstrahlfleck-Morphologie basierend auf dem maximalen Absolutwert $D_{Amax}$ und dem durchschnittlichen Absolutwert $\overline{D}_A$, und Bezeichnen als $D_{Zmin}(1)$;

Schritt 3.2: Einstellen der Erregerstromsteuerdaten $D_R$ der ersten anastigmatischen Wicklung auf $D_{Rmin}-\Delta D_{RT}$ und der Erregerstromsteuerdaten $D_T$ der zweiten anastigmatischen Wicklung auf $D_{Tmin}$ durch die zentrale Steuerung (1), und Ändern des Erregerstroms der anastigmatischen Vorrichtung (6); und Ausgeben eines gepulsten Elektronenstrahl-Steuerspannungssignals $U_{BS}$ durch die zentrale Steuerung (1), Abtasten eines Ausgangsspannungssignals $U_A$ der Signalverarbeitungsschaltung (4) mit der Abtastperiode $\mu$ innerhalb der Zeitdauer $\tau$ des gepulsten Elektronenstrahl-Steuerspannungssignals $U_{BS}$, und Erlangen des maximalen Absolutwerts $D_{Amax}$ und des durchschnittlichen Absolutwerts $\overline{D}_A$ der abgetasteten Daten des Ausgangsspannungssignals $U_A$; und dann Berechnen der aktuellen integrierten Daten Dz von Elektronenstrahlfleck-Morphologie basierend auf dem maximalen Absolutwert $D_{Amax}$ und dem durchschnittlichen Absolutwert $\overline{D}_A$, und Bezeichnen als $D_{Zmin}(2)$;

Schritt 3.3: Vergleichen der integrierten Daten $D_{Zmin}(0)$, $D_{Zmin}(1)$ und $D_{Zmin}(2)$ der Elektronenstrahlfleck-Morphologie durch die zentrale Steuerung (1):

wenn $D_{Zmin}(0)$ das Minimum ist, Zuweisen des Werts von $D_{Zmin}(0)$ zu Dzmin(3) und Beibehalten von $D_{Rmin}$ unverändert;
wenn $D_{Zmin}(1)$ das Minimum ist, Zuweisen des Werts von Dzmin(1) zu Dzmin(3) und Zuweisen des Werts von $D_{Rmin}+\Delta D_{RT}$ zu $D_{Rmin}$;
wenn $D_{Zmin}(2)$ das Minimum ist, Zuweisen des Werts von Dzmin(2) zu Dzmin(3) und Zuweisen des Werts von $D_{Rmin}-\Delta D_{RT}$ zu $D_{Rmin}$;

Schritt 4: Suchen der bevorzugten Erregerstromsteuerdaten $D_{Tmin}$ der zweiten anastigmatischen Wicklung durch Test; d. h.:

Schritt 4.1: Einstellen der Erregerstromsteuerdaten $D_R$ der ersten anastigmatischen Wicklung auf $D_{Rmin}$ und der Erregerstromsteuerdaten $D_T$ der zweiten anastigmatischen Wicklung auf $D_{Tmin}+\Delta D_{TR}$ durch die zentrale Steuerung (1), und Ändern des Erregerstroms der anastigmatischen Vorrichtung (6); und Ausgeben eines gepulsten Elektronenstrahl-Steuerspannungssignals $U_{BS}$ durch die zentrale Steuerung (1), Abtasten eines Ausgangsspannungssignals $U_A$ der Signalverarbeitungsschaltung (4) mit der Abtastperiode $\mu$ innerhalb der Zeitdauer $\tau$ des gepulsten Elektronenstrahl-Steuerspannungssignals $U_{BS}$, und Erlangen des maximalen Absolutwerts $D_{Amax}$ und des durchschnittlichen Absolutwerts $\overline{D}_A$ der abgetasteten Daten des Ausgangsspannungssignals $U_A$; und dann Berechnen der aktuellen integrierten Daten Dz von Elektronenstrahlfleck-Morphologie basierend auf dem maximalen Absolutwert $D_{Amax}$ und dem durchschnittlichen Absolutwert $\overline{D}_A$, und Bezeichnen als $D_{Zmin}(4)$;

Schritt 4.2: Einstellen der Erregerstromsteuerdaten $D_R$ der ersten anastigmatischen Wicklung auf $D_{Rmin}$ und der Erregerstromsteuerdaten $D_T$ der zweiten anastigmatischen Wicklung auf $D_{Tmin}-\Delta D_{TR}$ durch die zentrale Steuerung (1), und Ändern des Erregerstroms der anastigmatischen Vorrichtung (6); und Ausgeben eines gepulsten Elektronenstrahl-Steuerspannungssignals $U_{BS}$ durch die zentrale Steuerung (1), Abtasten eines Ausgangsspannungssignals $U_A$ der Signalverarbeitungsschaltung (4) mit der Abtastperiode $\mu$ innerhalb der Zeitdauer $\tau$ des gepulsten Elektronenstrahl-Steuerspannungssignals $U_{BS}$, und Erlangen des maximalen Absolutwerts $D_{Amax}$ und des durchschnittlichen Absolutwerts $D_A$ der abgetasteten Daten des Ausgangsspannungssignals $U_A$; und dann Berechnen der aktuellen integrierten Daten Dz von Elektronenstrahlfleck-Morphologie basierend auf dem maximalen Absolutwert $D_{Amax}$ und dem durchschnittlichen Absolutwert $\overline{D}_A$, und Bezeichnen als $D_{Zmin}(5)$;

Schritt 4.3: Vergleichen der integrierten Daten $D_{Zmin}(3)$, $D_{Zmin}(4)$ und $D_{Zmin}(5)$ der Elektronenstrahlfleck-Morphologie durch die zentrale Steuerung (1):

wenn $D_{Zmin}(3)$ das Minimum ist, Zuweisen des Werts von $D_{Zmin}(3)$ zu $D_{Zmin}(6)$ und Beibehalten von $D_{Tmin}$ unverändert;
wenn $D_{Zmin}(4)$ das Minimum ist, Zuweisen des Werts von $D_{Zmin}(4)$ zu $D_{Zmin}(6)$ und Zuweisen des Werts von $D_{Tmin}+\Delta D_{RT}$ zu $D_{Tmin}$;
wenn $D_{Zmin}(5)$ das Minimum ist, Zuweisen des Werts von $D_{Zmin}(5)$ zu $D_{Zmin}(6)$ und Zuweisen des Werts von $D_{Tmin}-\Delta D_{RT}$ zu $D_{Tmin}$;

Schritt 5: Beurteilen, ob die integrierten Daten den Mindestwert erreichen; d. h.:
Vergleichen der integrierten Daten $D_{Zmin}(6)$ und $D_{Zmin}(0)$ der Elektronenstrahlfleck-Morphologie durch die zentrale Steuerung (1):

wenn $D_{Zmin}(6) < D_{Zmin}(0)$, zuerst Einstellen der Endmarke K auf 0; und dann Zuweisen des Werts von $D_{Zmin}(6)$ zu $D_{Zmin}(0)$ und nach Zuweisen des Werts von $\lambda \times \Delta D_{RT}$ zu $\Delta D_{RT}$, Zurückkehren zu Schritt 3;
wenn $D_{Zmin}(6) \geq D_{Zmin}(0)$, zunächst Addieren von 1 zu der Endmarke K; und dann weiteres Beurteilen, ob die Endmarke K kleiner ist als der iterative Schwellenwert $\eta$:

wenn ja, Beibehalten von $D_{Zmin}(0)$ unverändert, Zuweisen des Werts von $k \times \Delta D_{RT}$ zu $\Delta D_{RT}$, und Zurückkehren zu Schritt 3;
andernfalls Speichern der bevorzugten Erregerstromsteuerdaten $D_{Rmin}$ der ersten anastigmatischen Wicklung, die schließlich in dem obigen Verfahren erlangt wurden, als die endgültigen Erregerstromsteuerdaten $D_R$ der ersten anastigmatischen Wicklung, und Speichern der bevorzugten Erregerstromsteuerdaten $D_{Tmin}$ der zweiten anastigmatischen Wicklung als endgültige Erregerstromsteuerdaten $D_T$ der zweiten anastigmatischen Wicklung, wodurch der automatische anastigmatische Test der Elektronenkanone abgeschlossen wird.

5. Automatisches anastigmatisches Verfahren für eine Elektronenkanone nach Anspruch 4, **dadurch gekennzeichnet, dass** in Schritt 1 der Anfangswert der bevorzugten Erregerstromsteuerdaten $D_{Rmin}$ der ersten anastigmatischen Wicklung auf 0 eingestellt wird, der Anfangswert der bevorzugten Erregerstromsteuerdaten $D_{Tmin}$ der zweiten anastigmatischen Wicklung auf 0 eingestellt wird, und der Anfangswert der Steuerungsabweichung $\Delta D_{RT}$ der Erregerstromsteuerdaten der ersten anastigmatischen Wicklung und der zweiten anastigmatischen Wicklung auf 0,5×$D_{RTM}$ eingestellt wird, wobei $D_{RTM}$ der Schwellenwert der anastigmatischen Wicklungen ist, d. h. $-D_{RTM} \leq D_R \leq D_{RTM}$, $-D_{RTM} \leq D_T \leq D_{RTM}$, $D_R$ die Erregerstromsteuerdaten der ersten anastigmatischen Wicklung sind, und $D_T$ die Erregerstromsteuerdaten der zweiten anastigmatischen Wicklung sind.

**6.** Automatisches anastigmatisches Verfahren für eine Elektronenkanone nach Anspruch 4, **dadurch gekennzeichnet, dass** innerhalb der Zeitdauer $\tau$ eines gepulsten Elektronenstrahl-Steuerspannungssignals $U_{BS}$ n abgetastete Daten des Ausgangsspannungssignals $U_A$ der Signalverarbeitungsschaltung (4) $D_{A1}$, $D_{A2}$, ..., $D_{An}$, sind, und für die abgetasteten Daten:

der maximale Absolutwert $D_{Amax}$ wie folgt ist:
$D_{Amax}=\max [|D_{A1}|,|D_{A2}|,...,|D_{An}|]$ der durchschnittliche Absolutwert $\overline{D}_A$ wie folgt ist:

$$\overline{D}_A = \frac{\left|D_{A1}\right| + \left|D_{A2}\right| + \cdots + \left|D_{An}\right|}{n}$$

wobei $n \approx \dfrac{\tau}{\mu}$ , $\tau$ die Zeitdauer des gepulsten Elektronenstrahl-Steuerspannungssignals $U_{BS}$ und $\mu$ die Abtastperiode ist.

**7.** Automatisches anastigmatisches Verfahren für eine Elektronenkanone nach Anspruch 5 oder 6, **dadurch gekennzeichnet, dass** die integrierten Daten Dz der Elektronenstrahlfleck-Morphologie wie folgt sind:

$$D_Z = \alpha \overline{D}_A + (1 - \alpha)D_{Amax}$$

wobei $D_{Amax}$ und $\overline{D}_A$ jeweils der maximale Absolutwert und der durchschnittliche Absolutwert der abgetasteten Daten des Ausgangsspannungssignals $U_A$ der Signalverarbeitungsschaltung (4) sind, $\alpha$ der gegebene gewichtete Wert des durchschnittlichen Absolutwerts $\overline{D}_A$ ist und $0 \leq \alpha \leq 1$.

**8.** Automatisches anastigmatisches Verfahren für eine Elektronenkanone nach Anspruch 4, **dadurch gekennzeichnet, dass** der iterative Schwellenwert $\eta=2$ ist.

**Revendications**

**1.** Canon à électrons anastigmatique automatique, comprenant un contrôleur central (1), une alimentation de source électronique (2), une alimentation d'entraînement (3) et un corps de canon à électrons (11) ;

un générateur de faisceaux d'électrons (5), un dispositif anastigmatique (6) et un dispositif de focalisation (7) sont disposés dans le corps de canon à électrons (11) de haut en bas ; et le dispositif anastigmatique (6) comprend des enroulements anastigmatiques à deux phases, qui forment une structure avec une pluralité de paires de pôles magnétiques axisymétriques ;
une extrémité de sortie de signal de tension de commande de faisceau d'électrons du contrôleur central (1) est connectée à une extrémité d'entrée de commande de l'alimentation de source électronique (2), et une extrémité de sortie de l'alimentation de source électronique (2) est connectée au générateur de faisceau d'électrons (5) ; une première extrémité de sortie de signal de tension de commande anastigmatique du contrôleur central (1) est connectée à une première extrémité d'entrée de commande de l'alimentation d'entraînement (3), et une première extrémité de sortie de l'alimentation d'entraînement (3) est connectée à un premier enroulement anastigmatique du dispositif anastigmatique (6) ; et une seconde extrémité de sortie de signal de tension de commande anastigmatique du contrôleur central (1) est connectée à une seconde extrémité d'entrée de commande de l'alimentation d'entraînement (3), et une seconde extrémité de sortie de l'alimentation d'entraînement (3) est connectée à un deuxième enroulement anastigmatique du dispositif anastigmatique (6) ;
**caractérisé en ce qu'**il comprend en outre un dispositif de détection (8) et un circuit de traitement de signal (4), le dispositif de détection (8) est disposé dans le corps de canon à électrons (11) et situé au niveau d'une extrémité de sortie du faisceau d'électrons (9) directement au-dessous du dispositif de focalisation (7) ; le dispositif de détection (8) comprend un cadre (85) et quatre enroulements de détection ; le cadre (85) comporte une structure annulaire en matériau isolant conducteur non magnétique ; les quatre enroulements comportent le même nombre de spires et le même diamètre de fil, et sont enroulés autour du cadre (85) et répartis uniformément et symétriquement ; un premier enroulement de détection (81) et un troisième enroulement de détection (83) sont disposés radialement de manière opposée sur le cadre (85), et l'extrémité de fin du premier enroulement de détection (81) est connectée à l'extrémité de début du troisième enroulement de détection (83); et un deuxième enroulement de détection (82) et un quatrième enroulement de détection (84) sont disposés radialement de manière opposée sur le cadre (85), et l'extrémité de fin du deuxième enroulement de détection (82) est connectée à l'extrémité de début du quatrième enroulement de détection (84) ;

l'extrémité de début du premier enroulement de détection (81) du dispositif de détection (8) est connectée à l'extrémité de début du deuxième enroulement de détection (82) puis connectée à une extrémité d'entrée commune du circuit de traitement de signal (4), l'extrémité de fin du troisième enroulement de détection (83) du dispositif de détection (8) est connectée à une seconde extrémité d'entrée du circuit de traitement de signal (4), et l'extrémité de fin du quatrième enroulement de détection (84) du dispositif de détection (8) est connectée à une première extrémité d'entrée du circuit de traitement de signal (4) ; et l'extrémité de sortie du circuit de traitement de signal (4) est connectée à l'extrémité d'entrée du contrôleur central (1).

**2.** Canon à électrons anastigmatique automatique selon la revendication 1, **caractérisé en ce que** le circuit de traitement de signal (4) est composé d'amplificateurs opérationnels A1 à A2, de résistances R1 à R8 et d'un condensateur C ;

une extrémité de la résistance R1 forme la première extrémité d'entrée du circuit de traitement de signal (4), une extrémité de la résistance R2 forme la seconde extrémité d'entrée du circuit de traitement de signal (4) et une extrémité de la résistance R3 forme l'extrémité d'entrée commune du circuit de traitement de signal (4) après avoir été connectée à un point commun de signal ; l'autre extrémité de la résistance R1 est connectée à une extrémité d'entrée anti-phase de l'amplificateur opérationnel A1 ; les autres extrémités de la résistance R2 et de la résistance R3 sont connectées simultanément à l'extrémité d'entrée en phase de l'amplificateur opérationnel A1 ; et une extrémité de la résistance R4 est connectée à l'extrémité d'entrée anti-phase de l'amplificateur opérationnel A1, et l'autre extrémité de la résistance R4 est connectée à une extrémité de sortie de l'amplificateur opérationnel A1 ;

l'extrémité de sortie de l'amplificateur opérationnel A1 est connectée à une extrémité de la résistance R5, et l'autre extrémité de la résistance R5 est connectée à une extrémité du condensateur C et à une extrémité de la résistance R6 ; l'autre extrémité du condensateur C et une extrémité de la résistance R7 sont connectées simultanément au point commun de signal, et l'autre extrémité de la résistance R7 est connectée à une extrémité d'entrée en phase de l'amplificateur opérationnel A2 ; l'autre extrémité de la résistance R6 est connectée à une extrémité d'entrée anti-phase de l'amplificateur opérationnel A2 ; une extrémité de la résistance R8 est connectée à l'extrémité d'entrée anti-phase de l'amplificateur opérationnel A2, et l'autre extrémité de la résistance R8 est connectée à une extrémité de sortie de l'amplificateur opérationnel A2 ; et l'extrémité de sortie de l'amplificateur opérationnel A2 forme l'extrémité de sortie du circuit de traitement de signal (4).

**3.** Canon à électrons anastigmatique automatique selon la revendication 2, **caractérisé en ce que** les résistances R1 et R2 comportent la même résistance, les résistances R3 et R4 comportent la même résistance, les résistances R5 et R6 comportent la même résistance, et la résistance

$$R7 = \frac{2 \times R5 \times R8}{2 \times R5 + R8}.$$

**4.** Procédé anastigmatique automatique pour canon à électrons selon la revendication 1, **caractérisé en ce qu'**il comprend les étapes suivantes :

étape 1 : initialisation : réglage de la valeur initiale des données préférées de commande de courant d'excitation $D_{Rmin}$ du premier enroulement anastigmatique, réglage de la valeur initiale des données préférées de commande de courant d'excitation $D_{Tmin}$ du deuxième enroulement anastigmatique, et réglage de la valeur initiale de l'écart de commande $\Delta D_{RT}$ ; réglage du coefficient de réduction $\lambda$ de l'écart de commande $\Delta D_{RT}$, dans lequel $0 < \lambda < 1$ ; réglage d'un signal de tension de commande de faisceau d'électrons pulsés $U_{BS}$ et d'une durée $\tau$ ; réglage d'une période d'échantillonnage $\mu$ ; et réglage d'un seuil itératif $\eta$, dans lequel $\eta$ est un nombre entier supérieur et égal à 1 ;

étape 2 : recherche des données intégrées d'origine de la morphologie du point de faisceau d'électrons dans l'état du dispositif anastigmatique (6) sans courant d'excitation par test ; à savoir :

démarrage d'un canon à électrons, et réglage des données de commande de courant d'excitation $D_R$ du premier enroulement anastigmatique et des données de commande de courant d'excitation $D_T$ du deuxième enroulement anastigmatique à 0 par le contrôleur central (1) de sorte que le courant d'excitation du dispositif anastigmatique (6) soit 0 ; et émission d'un signal de tension de commande de faisceau d'électrons pulsés $U_{BS}$ par le contrôleur central (1), échantillonnage d'un signal de tension de sortie $U_A$ du circuit de traitement de signal (4) à la période d'échantillonnage $\mu$ pendant la durée $\tau$ du signal de tension de commande de faisceau d'électrons pulsés $U_{BS}$, et obtention de la valeur absolue maximale $D_{Amax}$ et de la valeur absolue moyenne $\overline{D}_A$ des données échantillonnées du signal de tension de sortie $U_A$ ; puis calcul des données intégrées actuelles Dz de la morphologie de point de faisceau d'électrons sur la base de la valeur absolue maximale $D_{Amax}$ et de la valeur absolue moyenne $\overline{D}_A$, et désignation comme $D_{Zmin}(0)$,

étape 3 : recherche des données préférées de commande de courant d'excitation $D_{Rmin}$ du premier enroulement anastigmatique par test ; à savoir :

étape 3.1 : réglage des données de commande de courant d'excitation $D_R$ du premier enroulement anastigmatique sur $D_{Rmin}+\Delta D_{Rmin}$ et des données de commande de courant d'excitation $D_T$ du deuxième enroulement anastigmatique sur $D_{Tmin}$ par le contrôleur central (1), et modification du courant d'excitation du dispositif anastigmatique (6) ; et émission d'un signal de tension de commande de faisceau d'électrons pulsés $U_{BS}$ par le contrôleur central (1), échantillonnage d'un signal de tension de sortie $U_A$ du circuit de traitement de signal (4) à la période d'échantillonnage $\mu$ pendant la durée $\tau$ du signal de tension de commande de faisceau d'électrons pulsés $U_{BS}$, et obtention de la valeur absolue maximale $D_{Amax}$ et la valeur absolue moyenne $\overline{D}_A$ des données échantillonnées du signal de tension de sortie $U_A$ ; puis calcul des données intégrées actuelles Dz de la morphologie de point de faisceau d'électrons sur la base de la valeur absolue maximale $D_{Amax}$ et de la valeur absolue moyenne $\overline{D}_A$, et désignation comme $D_{Zmin}(1)$ ;

étape 3.2 : réglage des données de commande de courant d'excitation $D_R$ du premier enroulement anastigmatique sur $D_{Rmin}-\Delta D_{RT}$ et des données de commande de courant d'excitation $D_T$ du deuxième enroulement anastigmatique sur $D_{Tmin}$ par le contrôleur central (1), et modification du courant d'excitation du dispositif anastigmatique (6) ; et émission d'un signal de tension de commande de faisceau d'électrons pulsés $U_{BS}$ par le contrôleur central (1), échantillonnage d'un signal de tension de sortie $U_A$ du circuit de traitement de signal (4) à la période d'échantillonnage $\mu$ pendant la durée $\tau$ du signal de tension de commande de faisceau d'électrons pulsés $U_{BS}$, et obtention de la valeur absolue maximale $D_{Amax}$ et la valeur absolue moyenne $\overline{D}_A$ des données échantillonnées du signal de tension de sortie $U_A$ ; puis calcul des données intégrées actuelles Dz de la morphologie de point de faisceau d'électrons sur la base de la valeur absolue maximale $D_{Amax}$ et de la valeur absolue moyenne $\overline{D}_A$, et désignation comme $D_{Zmin}(2)$ ;

étape 3.3 : comparaison des données intégrées $D_{Zmin}(0)$, $D_{Zmin}(1)$ et $D_{Zmin}(2)$ de la morphologie des points du faisceau d'électrons par le contrôleur central (1) :

si $D_{Zmin}(0)$ est le minimum, attribution de la valeur de $D_{Zmin}(0)$ à $D_{Zmin}(3)$ et maintien de $D_{Rmin}$ inchangé ;
si $D_{Zmin}(1)$ est le minimum, attribution de la valeur de $D_{Zmin}(1)$ à $D_{Zmin}(3)$, et attribution de la valeur de $D_{Rmin}+\Delta D_{RT}$ à $D_{Rmin}$ ;
si $D_{Zmin}(2)$ est le minimum, attribution de la valeur de $D_{Zmin}(2)$ à $D_{Zmin}(3)$, et attribution de la valeur de $D_{Rmin}-\Delta D_{RT}$ à $D_{Rmin}$ ;

étape 4 : recherche des données préférées de commande de courant d'excitation $D_{Tmin}$ du deuxième enroulement anastigmatique par test ; à savoir :

étape 4.1 : réglage des données de commande de courant d'excitation $D_R$ du premier enroulement anastigmatique sur $D_{Rmin}$ et des données de commande de courant d'excitation $D_T$ du deuxième enroulement anastigmatique sur $D_{Tmin}+\Delta D_{TR}$ par le contrôleur central (1), et modification du courant d'excitation du dispositif anastigmatique (6) ; et émission d'un signal de tension de commande de faisceau d'électrons pulsés $U_{BS}$ par le contrôleur central (1), échantillonnage d'un signal de tension de sortie $U_A$ du circuit de traitement de signal (4) à la période d'échantillonnage $\mu$ pendant la durée $\tau$ du signal de tension de commande de faisceau d'électrons pulsés $U_{BS}$, et obtention de la valeur absolue maximale $D_{Amax}$ et la valeur

absolue moyenne $\overline{D}_A$ des données échantillonnées du signal de tension de sortie $U_A$ ; puis calcul des données intégrées actuelles Dz de la morphologie de point de faisceau d'électrons sur la base de la valeur absolue maximale $D_{Amax}$ et de la valeur absolue moyenne $\overline{D}_A$, et désignation comme $D_{Zmin}(4)$ ;

étape 4.2 : réglage des données de commande de courant d'excitation $D_R$ du premier enroulement anastigmatique sur $D_{Rmin}$ et des données de commande de courant d'excitation $D_T$ du deuxième enroulement anastigmatique sur $D_{Tmin}$-$\Delta D_{TR}$ par le contrôleur central (1), et modification du courant d'excitation du dispositif anastigmatique (6) ; et émission d'un signal de tension de commande de faisceau d'électrons pulsés $U_{BS}$ par le contrôleur central (1), échantillonnage d'un signal de tension de sortie $U_A$ du circuit de traitement de signal (4) à la période d'échantillonnage $\mu$ pendant la durée $\tau$ du signal de tension de commande de faisceau d'électrons pulsés $U_{BS}$, et obtention de la valeur absolue maximale $D_{Amax}$ et de la valeur absolue moyenne $\overline{D}_A$ des données échantillonnées du signal de tension de sortie $U_A$ ; puis calcul des données intégrées actuelles Dz de la morphologie de point de faisceau d'électrons sur la base de la valeur absolue maximale $D_{Amax}$ et de la valeur absolue moyenne $\overline{D}_A$, et désignation comme $D_{Zmin}(5)$ ;

étape 4.3 : comparaison des données intégrées $D_{Zmin}(3)$, Dzmm(4) et $D_{Zmin}(5)$ de la morphologie de point de faisceau d'électrons par le contrôleur central (1) :

si $D_{Zmin}(3)$ est le minimum, attribution de la valeur de $D_{Zmin}(3)$ à $D_{Zmin}(6)$, et maintien de $D_{Tmin}$ inchangé ;
si $D_{Zmin}(4)$ est le minimum, attribution de la valeur de $D_{Zmin}(4)$ à $D_{Zmin}(6)$, et attribution de la valeur de $D_{Tmin}$+$\Delta D_{RT}$ à $D_{Tmin}$ ;
si $D_{Zmin}(5)$ est le minimum, attribution de la valeur de $D_{Zmin}(5)$ à $D_{Zmin}(6)$, et attribution de la valeur de $D_{Tmin}$-$\Delta D_{RT}$ à $D_{Tmin}$ ;

étape 5 : détermination si les données intégrées atteignent la valeur minimale ; à savoir :
comparaison des données intégrées $D_{Zmin}(6)$ et $D_{Zmin}(0)$ de la morphologie de point de faisceau d'électrons par le contrôleur central (1) :

si $D_{Zmin}(6) < D_{Zmin}(0)$, d'abord réglage de la marque de fin K sur 0 ; puis attribution de la valeur de $D_{Zmin}(6)$ à $D_{Zmin}(0)$, et ensuite affection de la valeur de $\lambda \times \Delta D_{RT}$ à $\Delta D_{RT}$, retour à l'étape 3;
si $D_{Zmin}(6) \geq D_{Zmin}(0)$, d'abord ajout de 1 à la marque de fin K ; puis évaluation supplémentaire si la marque de fin K est inférieure au seuil itératif $\eta$ :

si tel est le cas, maintien de $D_{Zmin}(0)$ inchangé, attribution de la valeur de $\lambda \times \Delta D_{RT}$ à $\Delta D_{RT}$ et retour à l'étape 3 ;
sinon, stockage des données préférées de commande de courant d'excitation $D_{Rmin}$ du premier enroulement anastigmatique finalement obtenues dans le processus ci-dessus en tant que données finales de commande de courant d'excitation $D_R$ du premier enroulement anastigmatique, et stockage des données préférées de commande de courant d'excitation $D_{Tmin}$ du deuxième enroulement anastigmatique comme les données finales de commande de courant d'excitation $D_T$ du deuxième enroulement anastigmatique, terminant ainsi le test anastigmatique automatique du canon à électrons.

5. Procédé anastigmatique automatique pour canon à électrons selon la revendication 4, **caractérisé en ce qu'**à l'étape 1, la valeur initiale des données préférées de commande de courant d'excitation $D_{Rmin}$ du premier enroulement anastigmatique est réglée sur 0, la valeur initiale des données préférées de commande de courant d'excitation $D_{Tmin}$ du deuxième enroulement anastigmatique est réglée sur 0, et la valeur initiale de l'écart de commande $\Delta D_{RT}$ des données de commande de courant d'excitation du premier enroulement anastigmatique et du deuxième enroulement anastigmatique est réglée sur $0,5 \times D_{RTM}$, $D_{RTM}$ étant le seuil des enroulements anastigmatiques, à savoir, -$D_{RTM} \leq D_R \leq D_{RTM}$, -$D_{RTM} \leq D_T \leq D_{RTM}$, $D_R$ représente les données de commande de courant d'excitation du premier enroulement anastigmatique, et $D_T$ représente les données de commande de courant d'excitation du deuxième enroulement anastigmatique.

6. Procédé anastigmatique automatique pour canon à électrons selon la revendication 4, **caractérisé en ce que** pendant la durée $\tau$ d'un signal de tension de commande de faisceau d'électrons pulsés $U_{BS}$, n données échantillonnées du signal de tension de sortie $U_A$ du circuit de traitement de signal (4) sont $D_{A1}$, $D_{A2}$, ..., $D_{An}$, et pour les données échantillonnées :

la valeur absolue maximale $D_{Amax}$ est :

$$D_{Amax}=\max \left[|D_{A1}|,|D_{A2}|,...,|D_{An}|\right]$$

la valeur absolue moyenne $\overline{D}_A$ est :

$$\overline{D}_A = \frac{|D_{A1}| + |D_{A2}| + \cdots + |D_{An}|}{n}$$

dans lequel $n \approx \dfrac{\tau}{\mu}$ , $\tau$ est la durée du signal de tension de commande du faisceau d'électrons pulsés $U_{BS}$, et $\mu$ est la période d'échantillonnage.

7. Procédé anastigmatique automatique pour canon à électrons selon la revendication 5 ou 6, **caractérisé en ce que** les données intégrées Dz de la morphologie de point de faisceau d'électrons sont :

$$D_Z = \alpha \overline{D}_A + (1 - \alpha)D_{Amax}$$

dans lequel $D_{Amax}$ et $\overline{D}_A$ sont respectivement la valeur absolue maximale et la valeur absolue moyenne des données échantillonnées du signal de tension de sortie $U_A$ du circuit de traitement de signal (4), $\alpha$ est la valeur pondérée donnée de la valeur absolue moyenne $\overline{D}_A$, et $0 \le \alpha \le 1$.

8. Procédé anastigmatique automatique pour canon à électrons selon la revendication 4 **caractérisé en ce que** le seuil itératif $\eta=2$.

FIG. 1

FIG. 2

EP 3 951 828 B1

FIG. 3

FIG. 4

FIG. 5